# EUROPEAN PATENT APPLICATION

(11) **EP 2 333 840 A1**
(43) Date of publication of application: **15.06.2011**
(21) Application number: 09817549.0
(22) Date of filing: 04.06.2009
(51) Int. Cl.: H01L 29/786, G09F 9/00, G09F 9/30, H01L 21/20, H01L 21/336

(54) **DISPLAY PANEL AND DISPLAY DEVICE USING THE SAME**

(30) Priority: 02.10.2008 JP 2008257534
(71) Applicant: Sharp Kabushiki Kaisha, Osaka-shi, Osaka 545-8522 (JP)
(72) Inventor: MIYAMOTO, Tadayoshi, Abeno-ku, Osaka-shi, Osaka 545-8522 (JP); SUGA, Katsuyuki, Abeno-ku, Osaka-shi, Osaka 545-8522 (JP); YOSHIOKA, Fumiyoshi, Abeno-ku, Osaka-shi, Osaka 545-8522 (JP); HASEGAWA, Satomi, Abeno-ku, Osaka-shi, Osaka 545-8522 (JP)
(74) Representative: Treeby, Philip David William
(86) International application number: PCT/JP2009/060255
(87) International publication number: WO 2010/038511

(57) **Abstract**

A display panel (100) is provided which allows optimization of the respective characteristics of different semiconductor elements without incurring an increase in manufacturing cost. The display panel (100) includes: pixel TFTs (11) disposed in a display section (101); scanning driver TFTs (12) disposed in a scanning driver (102); and data driver (13) disposed in a data driver (103). A polysilicon film of the pixel TFTs **(11),** the scanning driver TFTs (12)**,** and the data driver TFTs (13) is polycrystallized by irradiation of laser light so as to have a crystal growth direction that goes along a scanning direction of the laser light. The pixel TFTs (11) are disposed so that the crystal growth direction of the polysilicon film is substantially perpendicular to the directions of current paths of the pixel TFTs (11). The scanning driver TFTs (12) and the data driver TFTs (13) are so that the crystal growth direction of the polysilicon film is substantially parallel to the directions of current paths of the scanning driver TFTs (12) and the data driver TFTs (13).

## Description

### Technical Field

The present invention relates to a display panel having peripheral driving circuits built-in and a display device using such a display panel.

### Background Art

Conventionally, as liquid crystal displays have become higher in resolution, they have come to have peripheral driving circuits built-in using thin-film transistors (hereinafter referred to as "TFTs"). In such a liquid crystal display having peripheral driving circuits built-in, it is common to use high-mobility TFTs to make up a peripheral driving circuit while using low leak current TFTs to make up a pixel section for driving liquid crystals.

Furthermore, in the case of a liquid crystal display that senses input coordinates by blocking light and/or controls display screen luminance by sensing external light, TFTs that make up a light sensor are required to induce stronger low-leak currents than those which make up a pixel section.

Proposed in consideration of such a requirement is a method by which when TFTs that make up a pixel section (referred to as "pixel TFTs" here), TFTs that make up a peripheral driving circuit (referred to as "driving TFTs" here), and TFTs that make up a light sensor (referred to as "light sensor TFTs" here) are fabricated on the same substrate, only a semiconductor film of each of the light sensor TFTs is recrystallized by subjecting only the semiconductor film of the light sensor TFT to laser annealing twice (e.g., see Patent Literature 1).

This method improves the crystal properties of the semiconductor film of the light sensor TFT by making the semiconductor film of the light sensor TFT larger in crystal grain diameter than those of the pixel and driving TFTs, thereby achieving an increase in efficiency in the generation of a photocurrent by the light sensor TFT.

### Citation List

### Patent Literature 1

Japanese Patent Application Publication, Tokukai, No. 2005-250454 (Publication Date: September 15, 2005)

### Summary of Invention

### Technical Problem

However, in order to optimize the TFT characteristics of the light sensor, the method disclosed in Patent Literature 1 requires that only the semiconductor film of the light sensor TFT be crystallized twice. This results in an increase in number of production steps for producing a semiconductor film from which TFTs are formed, thus suppressing a reduction in cost of manufacturing liquid crystal displays.

In order to solve the foregoing problems, the present invention has as an object to provide a display panel that allows optimization of the respective characteristics of different semiconductor elements without incurring an increase in manufacturing cost and a display device using such a display panel.

### Solution to Problem

In order to attain the foregoing object, a display panel according to the present invention is a display panel including: a transparent substrate; a semiconductor film disposed above or on the transparent substrate; and a plurality of semiconductor elements respectively having current paths, the current paths being formed from the semiconductor film, the semiconductor film being polycrystallized by irradiation of laser light so as to have a crystal growth direction that goes along a scanning direction of the laser light, the plurality of semiconductor elements including: first semiconductor elements disposed above or on the transparent substrate so that the crystal growth direction of the semiconductor film is substantially perpendicular to directions of the current paths of the first semiconductor elements; and second semiconductor elements disposed above or on the transparent substrate so that the crystal growth direction of the semiconductor film is substantially parallel to directions of the current paths of the second semiconductor elements.

In the display panel above, when the semiconductor film disposed above or on the transparent substrate is polycrystallized by irradiation of laser light, the growth of a crystal in a direction that goes along a scanning direction of the laser light is achieved.

Moreover, as semiconductor elements using the semiconductor film as their respective current paths, first semiconductor elements are disposed above or on the transparent substrate so that the directions of the current paths of the first semiconductor elements are substantially perpendicular to the crystal growth direction of the semiconductor film, and second semiconductor elements are disposed above or on the transparent substrate so that the directions of the current paths of the second semiconductor elements are substantially parallel to the crystal growth direction of the semiconductor film.

That is, by disposing semiconductor elements as described above with respect to a semiconductor film having a crystal growth direction that goes along a scanning direction of laser beam, first semiconductor elements the directions of whose current paths are substantially perpendicular to the crystal growth direction of the semiconductor film and second semiconductor elements the directions of whose current paths are substantially parallel to the crystal growth direction of the semiconductor film can be realized.

This makes it possible to realize first and second semiconductor elements having different characteristics from each other due to a difference in direction of current paths with respect to the crystal growth direction of a semiconductor film, thus making it possible to reduce the cost of manufacturing display panels using these two types of semiconductor elements, i.e., first and second semiconductor elements.

Further, a display device according to the present invention includes: a display panel described above; and a control device for controlling image display processing performed by the display panel.

The display device realizes a display device including a display panel described above.

### Advantageous Effects of Invention

In a display panel according to the present invention, as described above, the semiconductor film is polycrystallized by irradiation of laser light so as to have a crystal growth direction that goes along a scanning direction of the laser light, the plurality of semiconductor elements including: first semiconductor elements disposed above or on the transparent substrate so that the crystal growth direction of the semiconductor film is substantially perpendicular to directions of the current paths of the first semiconductor elements; and second semiconductor elements disposed above or on the transparent substrate so that the crystal growth direction of the semiconductor film is substantially parallel to directions of the current paths of the second semiconductor elements.

This brings about an effect of allowing optimization of the respective characteristics of different semiconductor elements without incurring an increase in manufacturing cost.

### Brief Description of Drawings

Fig. 1

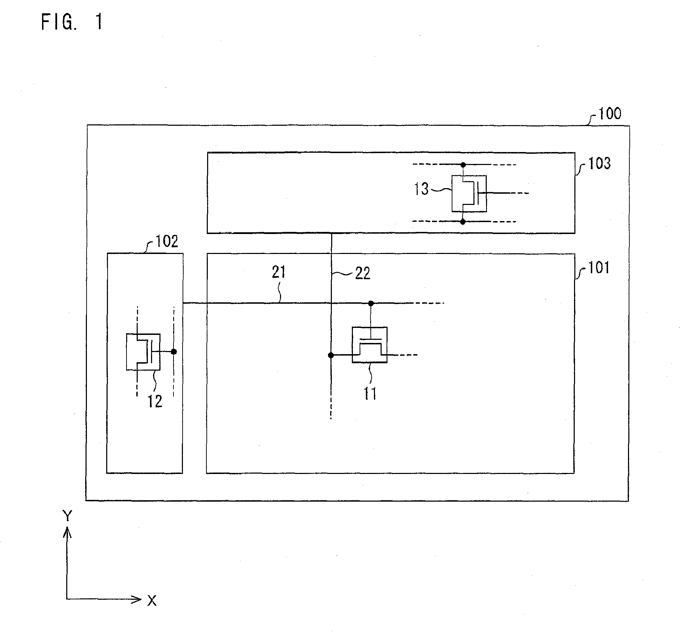

   Fig. 1 is a plan view schematically showing the configuration of a display panel according to Embodiment 1 of the present invention.
Fig. 2

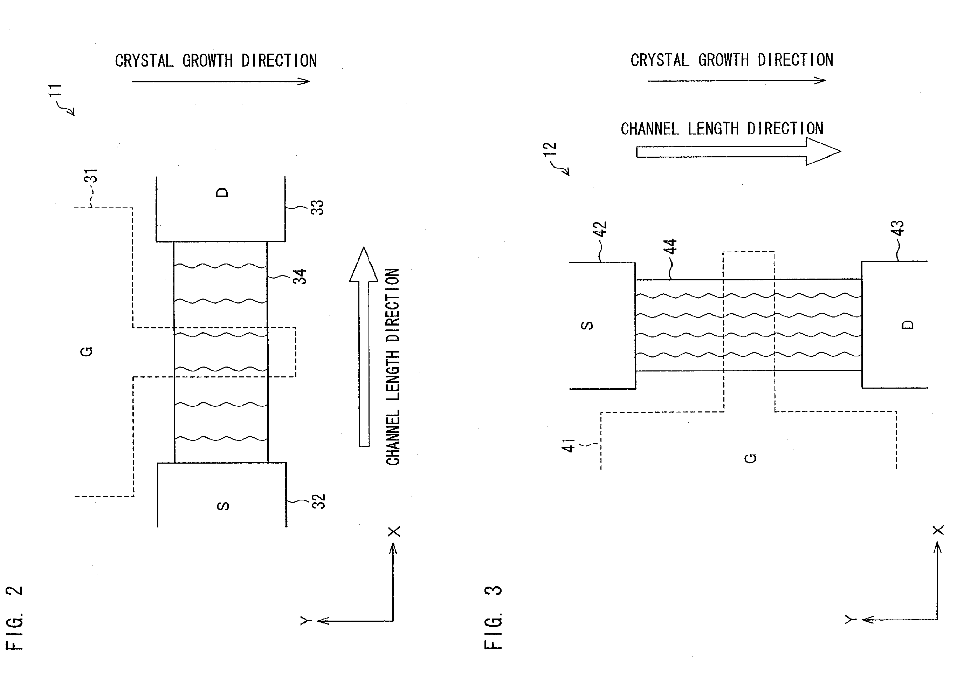

   Fig. 2 is an explanatory diagram for explaining how the channel region of a pixel TFT looks.
Fig. 3
   Fig. 3 is an explanatory diagram for explaining how the channel region of a scanning driver TFT looks.
Fig. 4

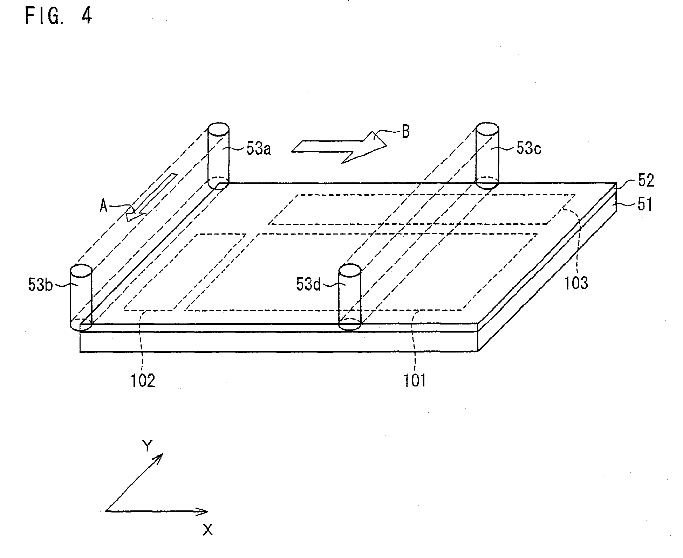

   Fig. 4 is an explanatory diagram for explaining how an amorphous silicon film is polycrystallized.
Fig. 5

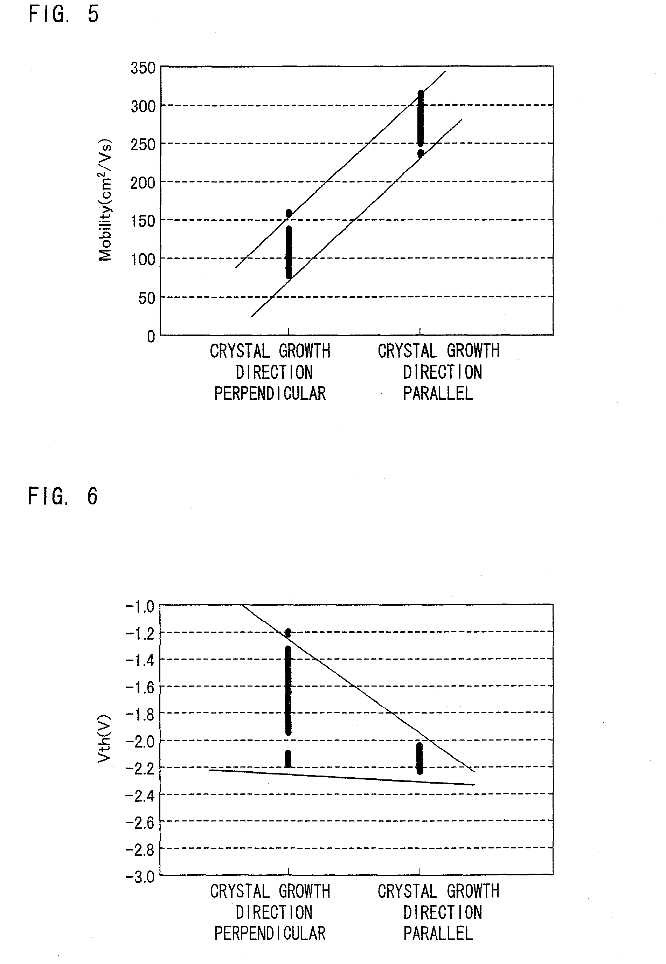

   Fig. 5 is a graph showing a relationship between the crystal growth direction of a polysilicon film and the mobility.
Fig. 6
   Fig. 6 is a graph showing a relationship between the crystal growth direction of a polysilicon film and the threshold voltage.
Fig. 7

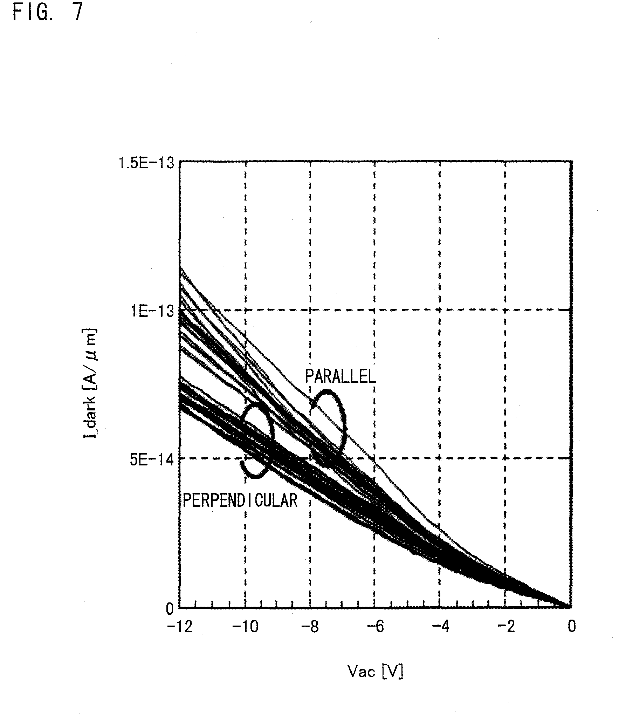

   Fig. 7 is a graph showing a relationship between the crystal growth direction of a polysilicon film and the leak current.
Fig. 8

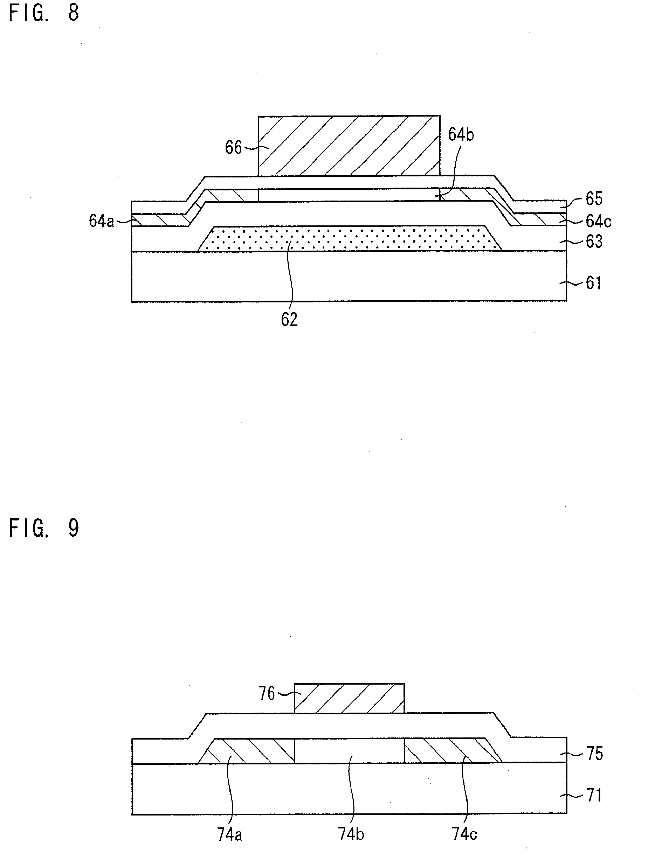

   Fig. 8 is a cross-sectional view of a pixel TFT.
Fig. 9
   Fig. 9 is a cross-sectional view of a scanning driver TFT.
Fig. 10

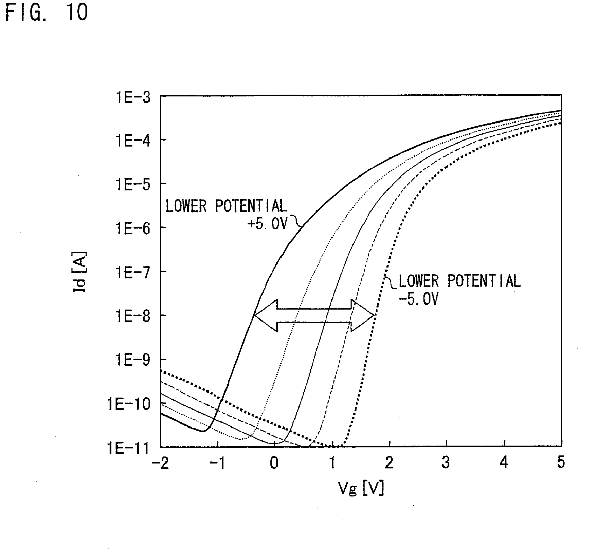

   Fig. 10 is a graph showing a relationship between the potential of the gate electrode of a pixel TFT and the drain current.
Fig. 11

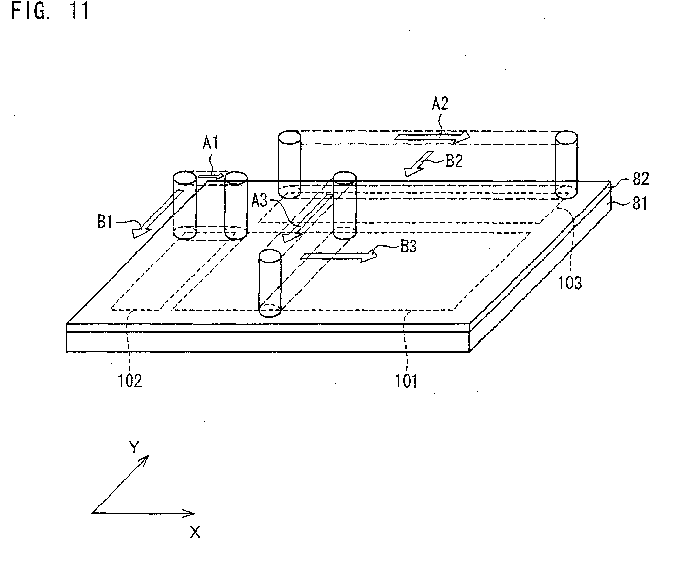

   Fig. 11 is an explanatory diagram for explaining how an amorphous silicon film is polycrystallized.

### Description of Embodiments

Embodiments of the present invention are described below with reference to the drawings. In the drawings, identical or similar parts are given identical or similar reference numerals. However, the drawings are supposed to be schematic; that is to say, a relationship between thickness and plane dimensions, the thickness ratio of one layer to another, etc. are different from those in reality. Further, the drawings are partly different in dimensional relationship and ratio from one another.

### (Embodiment 1)

A display panel according to Embodiment 1 of the present invention is a liquid crystal display panel made up of two glass substrates opposite each other and a liquid crystal material sandwiched therebetween. One of the two glass substrates is a TFT array substrate (hereinafter referred to as "TFT substrate") having TFTs and a transparent pixel electrode layer provided thereon in a matrix manner, and the other is a color filter substrate (hereinafter referred to as "CF substrate") having a coloring layer and a transparent counter electrode layer provided thereon.

Moreover, the display panel according to the present embodiment is produced through an array step of fabricating such a TFT substrate and such a CF substrate, a panel step of making a liquid crystal display panel by joining the TFT substrate and the CF substrate on top of each other and injecting liquid crystals into the space therebetween, and a module step of processing the liquid crystal display panel so that it becomes electrically controllable. It should be noted that the step of fabricating the CF substrate in the array step, the panel step, and the module step are identical to those publicly known.

Further, in the display panel according to the present embodiment, a semiconductor film of each of the TFTs provided on the TFT substrate is a polysilicon film polycrystallized by a CW (continuous-wave) solid-state laser. The polysilicon film polycrystallized by a CW solid-state laser has advantages of being larger in crystal grain diameter and being small in surface unevenness than that polycrystallized by irradiation of an excimer laser.

Furthermore, the polysilicon film polycrystallized by a CW solid-state laser has crystal anisotropy and therefore varies in properties depending on its crystal growth direction. That is, this polysilicon film laterally grows to have a shape elongated in one direction, for example, by several micrometers or more.

It should be noted that by providing the display panel according to the present embodiment with a control device for controlling image display processing performed by the display panel, a display device including the display panel is realized.

A display panel according to the present embodiment is described below with reference to the drawings. Fig. 1 is a plan view schematically showing the configuration of a display panel according to the present embodiment.

As shown in Fig. 1, a display panel 100 according to the present embodiment includes: a display section 101; a scanning driver (driving section) 102, which is a peripheral driving circuit; and a data driver (driving section) 103, which is a peripheral driving circuit. The display section 101, the scanning driver 102, and the data driver 103 are provided on the same TFT substrate.

The display section 101 has a plurality of pixel sections disposed therein in a matrix manner, and each of the pixel sections has disposed therein: a liquid crystal cell (not illustrated) having a pixel electrode; and a liquid crystal cell driving TFT (hereinafter referred to as "pixel TFT") (semiconductor element, first semiconductor element, first thin-film transistor) 11, connected to the pixel electrode, which corresponds one-to-one with the pixel section. That is, the pixel TFTs 11 are disposed in the display section 101 of the display panel 100. To facilitate visualization, Fig. 1 shows only one pixel TFT 11.

The pixel TFT 11, which has a low leak current characteristic, suppresses an off-leak current flowing during an off period of the pixel TFT 11 to low levels, thereby preventing variations in image quality among the pixel sections within the display section 101.

Moreover, the pixel TFT 11 has a gate electrode that is supplied with a scanning signal (driving signal) from the scanning driver 102 through a gate wire 21. Further, the pixel TFT 11 has a source electrode that is supplied with a data signal (driving signal) from the data driver 103 through a source wire 22. In this way, each pixel electrode receives a data signal through a pixel TFT selected by a scanning signal. Each gate wire 21 and each source wire 22 are disposed to be orthogonal to each other around the pixel section. To facilitate visualization, Fig. 1 shows only one gate wire 21 and one source wire 22.

As shown in Fig. 1, the scanning driver 102 and the data driver 103 are built in the display panel 100. To this end, the scanning driver 102 is made up of a plurality of TFTs (hereinafter referred to as "scanning TFTs") (semiconductor elements, second semiconductor elements, second thin-film transistors) provided on the TFT substrate, and the data driver 103 is made up of a plurality of TFTs (hereinafter referred to as "data driver TFTs") (semiconductor elements, second semiconductor elements, second thin-film transistors) provided on the TFT substrate. That is, the scanning driver TFTs 12 are disposed in the scanning driver 102 of the display panel 100, and the data driver TFT 13 are disposed in the data driver 103 of the display panel 100. To facilitate visualization, Fig. 1 shows only one scanning driver TFT 12 and one data driver TFT 13.

The scanning driver TFT 12 and the data driver TFT 13, which have high levels of carrier mobility, both operate at high speeds to execute high-speed on-off control (switching control) for a corresponding one of the pixel TFTs 11 disposed in the display section 101, thereby realizing quick writing of image data to the liquid crystal cell connected to the pixel TFT 11.

Moreover, the scanning driver TFT 12 and the data driver TFT 13 have channel regions whose channel length directions both go along a Y direction of Fig. 1. On the other hand, the pixel TFT 11, which constitutes a pixel section of the display section 101, has a channel region whose channel length direction goes along an X direction of Fig. 1.

That is, in the display panel 100 according to the present embodiment, the pixel TFTs 11, the scanning driver TFTs 12, and the data driver TFTs 13 are disposed so that the channel length directions of the channel regions of the scanning driver and data driver TFTs 12 and 13 and the channel length directions of the channel regions of the pixel TFTs 11 are orthogonal to each other.

The following describes the configuration of each pixel TFT 11, the configuration of each scanning driver TFT 12, and the configuration of each data driver TFT 13.

Fig. 2 is an explanatory diagram for explaining how the channel region of a pixel TFT 11 looks. Fig. 3 is an explanatory diagram for explaining how the channel region of a scanning driver TFT 12 looks. Fig. 4 is an explanatory diagram for explaining how an amorphous silicon film deposited on the TFT substrate constituting the display panel 100 is polycrystallized. In the present embodiment, a scanning driver TFT 12 and a data driver TFT 13 can be realized by identical components. To avoid repetition in a description of a scanning driver TFT 12, the following omits to describe a data driver TFT 13.

As shown in Fig. 2, each pixel TFT 11 has a gate electrode 31, a source electrode 32, a drain electrode 33, and a channel region 34. The channel length direction of the channel region 34, i.e., the direction of travel of carriers (electrons, positive holes) that travel from the source electrode 32 toward the drain electrode 33, is orthogonal to the crystal growth direction of a polysilicon film (which will be described later) from which the channel region 34 (current path) is formed.

On the other hand, as shown in Fig. 3, each scanning driver TFT 12 has a gate electrode 41, a source electrode 42, a drain electrode 43, and a channel region 44. The channel length direction of the channel region 44, i.e., the direction of travel of carriers that travel from the source electrode 42 toward the drain electrode 43, is orthogonal to the crystal growth direction of a polysilicon film (which will be described later) from which the channel region 44 (current path) is formed.

A polysilicon film from which the channel regions 33 and 44 are formed is described here with reference to Fig. 4.

As shown in Fig. 4, laser light emitted from a CW solid-state laser light source (not illustrated) is condensed, for example, into small-diameter beam laser light (laser light) 53a to 53d having a diameter of 0.1 mm to 2 mm, and the small-diameter beam laser light 53a to 53d is made to shine on an amorphous silicon film (semiconductor film) 52 deposited on a TFT substrate 51.

Although not illustrated, the display panel 100 is provided with an optical system for condensing the laser light emitted from the CW solid-state laser light source (not illustrated) into the small-diameter beam laser light 53a to 53d and passing the small-diameter beam laser light 53a to 53d over the amorphous silicon film 52.

The small-diameter beam laser light 53a to 53d is made to shine on the amorphous silicon film 52 in this order. Specifically, the small-diameter beam laser light is passed from the position of the small-diameter beam laser light 53a to the position of the small-diameter beam laser light 53b in the direction of an arrow A of Fig. 4 along a Y direction of Fig. 4. Then, the small-diameter beam laser light thus passed forms a band of light that moves in the direction of an arrow B of Fig. 4 so that adjacent bands of light overlap each other, for example, by approximately 10 µm.

The amorphous silicon film 52 is polycrystallized by irradiation of the small-diameter beam laser light 53a to 53d to turn into a polysilicon film from which the channel region 34 of each pixel TFT 11 and the channel region 44 of each driver TFT 12 are formed. The polysilicon film serves as a polysilicon film from which the pixel TFTs 11 disposed in the display section 101, the scanning driver TFT 12 disposed in the scanning driver 102, and the data driver TFT 13 disposed in the data driver 103 are formed.

It should be noted here that the scanning direction in which the small-diameter beam laser light 53a to 53d is passed over the amorphous silicon film 52 deposited on the TFT substrate 51 stays the same anywhere on the amorphous silicon film 52.

Moreover, the scanning direction in which the small-diameter beam laser light 53a to 53d is passed determines the crystal growth direction of the polysilicon film. That is, in Fig. 4, the crystal growth direction of the polysilicon film coincides with the direction of the arrow A of Fig. 4.

That is, the crystal growth direction of the polysilicon film from which the pixel TFTs 11, the scanning driver TFTs 12, and the data driver TFTs 13 are formed is all along the direction of the arrow A of Fig. 4.

Therefore, in the pixel TFTs 11 disposed in the display section 101, as shown in Figs. 1 and 2, the channel length directions of the channel regions 34 go along the X direction in the drawings, and the crystal growth direction of the polysilicon film from which the channel regions 34 are formed is perpendicular (substantially perpendicular) to the channel length directions.

On the other hand, in the scanning driver TFTs 12 disposed in the scanning driver 102 and the data driver TFTs 13 disposed in the data driver 103, as shown in Figs. 1 and 3, the channel length directions of the channel regions 44 go along the Y direction in the drawings, and the crystal growth direction of the polysilicon film from which the channel regions 44 are formed is parallel (substantially parallel) to the channel length directions.

Fig. 5 is a graph showing a relationship between the crystal growth direction of a polysilicon film and the mobility, and Fig. 6 is a graph showing a relationship between the crystal growth direction of a polysilicon film and the threshold voltage. As shown in Figs. 5 and 6, in the case of a polysilicon film having its crystal growth direction parallel to the channel length directions, i.e., in the case of the scanning driver TFTs 12 and the data driver TFTs 13 shown in Figs. 1 and 3, high mobility and a low threshold voltage are realized. Furthermore, there is also higher uniformity in threshold voltage.

That is, the scanning driver TFTs 12 and the data driver TFTs 13 are realized as high-speed TFTs low in threshold voltage and capable of high-speed driving. For this reason, the scanning driver TFTs 12 and the data driver TFTs 13 are TFTs that are suitable to making up the scanning driver 102 and the data driver 103, which are peripheral driving circuits required of high-speed driving.

Further, Fig. 7 is a graph showing a relationship between the crystal growth direction of a polysilicon film and the leak current. The leak current shown in Fig. 7 indicates the I-V characteristic of a diode element formed from the polysilicon film, i.e., a dark current with respect to a reverse bias voltage.

As shown in Fig. 7, in the case of a polysilicon film having its crystal growth direction perpendicular to the direction of a current, the diode element realizes a low leak current. This means that the pixel TFTs 11, shown in Figs. 1 and 2, where the polysilicon film has its crystal growth direction perpendicular to the channel length directions realize low leak currents.

That is, the pixel TFTs 11 are realized as TFTs capable of reducing off-leak currents. For this reason, the pixel TFTs are TFTs that are suitable to making up the display section 101, which is required to exhibit high charge retention properties in each of its pixel sections.

By thus utilizing anisotropy in crystal growth direction as generated during polycrystallization using a CW solid-state laser, the scanning driver TFTs 12, which make up the scanning driver 102, and the data driver TFTs 13, which make up the data driver 103, are disposed so that their channel regions 44 have channel length directions that are identical to the scanning direction in which the CW solid-state laser is passed. Further, by utilizing the anisotropy in crystal growth direction, the pixel TFTs 11, which make up the display section 101, are disposed so that their channel regions 34 have channel length directions that are perpendicular to the scanning direction in which the CW solid-state laser is passed. Simply by thus disposing the pixel TFTs 11, the scanning driver TFTs 12, and the data driver TFTs 13, their respective characteristics can be optimized.

That is, the respective characteristics of the pixel TFTs 11, the scanning driver TFTs 12, and the data driver TFTs 13 can be optimized by a single irradiation of the laser light, without carrying out polycrystallization more than once using a CW solid-state laser.

The following details the structure of each pixel TFT 11, the structure of each scanning driver TFT 12, and the structure of each data driver TFT 13. In the present embodiment, a scanning driver TFT 12 and a data driver TFT 13 can be realized by identical components. To avoid repetition in a description of a scanning driver TFT 12, the following omits to describe a data driver TFT 13.

Fig. 8 is a cross-sectional view of a pixel TFT 11. As shown in Fig. 8, the pixel TFT 11 includes: a light blocking film 62 disposed on a transparent substrate 61; an insulating film 63 disposed in such a way as to cover the light blocking film 62; a polysilicon film, disposed on the insulating film 63, which has a source region 64a, a channel region 64b, and a drain region 64c; an insulating film 65 disposed on the polysilicon film; and a gate electrode 66 disposed on the insulating film 65.

In this pixel TFT 11**,** the light blocking film 62 blocks incident light coming from the transparent substrate 61, thereby suppressing deterioration of the polysilicon film by light and generation of a light leak current. This makes the pixel TFT 11 a TFT that is suitable to constituting the display section 100, which requires a light blocking effect.

The structure of this pixel TFT 11 can be realized, for example, as follows: First, a conducting layer formed by publicly known sputtering on one surface of a transparent substrate 61 that has been cleansed is patterned into a desired shape in a photolithography step to form a light blocking film 62 having a film thickness of 70 nm to 300 nm, or more preferably 100 nm to 200 nm.

For electrical conductivity, the light blocking film 62 can be made of a high-melting-point metal such as tantalum (Ta), tungsten (W), titanium (Ti), or molybdenum (Mo), an alloy composed mainly of such a high-melting-point metal, or a compound composed mainly of such a high-melting-point metal.

Next, an insulating film 63 having a film thickness of 100 nm to 500 nm, or more preferably 150 nm to 300 nm, is formed on the transparent substrate 61 in such a way as to cover the light blocking film 62.

The insulating film 63 can be realized by an inorganic insulating film containing silicon (Si), e.g., a SiO₂ film, a SiN film, or a SiNO film, formed, for example, by publicly known plasma CVD or sputtering. In particular, from a point of view of effectively suppressing diffusion of impurity ions from the transparent substrate 61, it is preferable that the insulating film 63 be an inorganic insulating film containing nitrogen such as a SiN film or a SiNO film. Further, the insulating film 63 may be a laminated structure having a plurality of films joined on top of each other.

Next, an amorphous silicon film is formed on the insulating film 63 by publicly known sputtering, LPCVD, or plasma CVD. Then, after polycrystallization of the amorphous silicon film by irradiation of a CW solid-state laser, the amorphous silicon film is patterned into a desired shape in a photolithography step to form a polysilicon film having a film thickness of 20 nm to 100 nm, more preferably 30 nm to 70 nm.

Next, an insulating film 65 having a film thickness of 30 nm to 150 nm, or more preferably 50 nm to 100 nm, is formed above the transparent substrate 61 in such a way as to cover the polysilicon film.

From a point of view of lowering the surface level at the interface with the polysilicon film, it is preferable that the insulating film 65 be a SiO₂ film. Further, the insulating film 65 may be a laminated structure having a plurality of films joined on top of each other.

Next, for adjustment of threshold voltage, the entire surface of the polysilicon film is doped (channel doping) with impurities through the insulating film 65 by publicly known ion injection or ion doping.

For realization of an n-type TFT, the impurities for use in the channel doping may be an element of Family III such as boron (B). Alternatively, for realization of a p-type TFT, the impurities for use in the channel doping may be an element of Family V such as phosphor (P). Further, for treatment of a large-area substrate, ion doping is preferred.

Next, a conducting layer formed by publicly known sputtering on the insulating film 65 is patterned into a desired shape in a photolithography step to form a gate electrode 66 having a film thickness of 100 nm to 500 nm, or more preferably 150 nm to 300 nm.

Next, after a cap film (not illustrated) having a film thickness of 20 nm to 150 nm, or more preferably 30 nm to 100 nm, is formed in such a way as to cover the gate electrode 66, the polysilicon film is doped (source-drain heavy doping) with impurities such as boron (B) or phosphor (P) in a self-aligning manner by publicly known ion injection or ion doping. It should be noted that by providing an LDD region at an end of each of the source and drain regions 64a and 64c facing the gate electrode 66, the effect of a low leak current can be further enhanced.

The cap film can be realized by an inorganic insulating film containing silicon (Si), e.g., a SiO₂ film, a SiN film, or a SiNO film, formed, for example, by publicly known plasma CVD and sputtering.

Next, after a process of activating the polysilicon film, a high concentration impurity region that functions as the source and drain regions 64a and 64c is formed in a region of the polysilicon film excluding the channel region 64b.

The process of activating the polysilicon film may be realized, for example, by treating the polysilicon film with heat using an annealing oven or the like or irradiating the polysilicon film with an excimer laser or the like.

Finally, after a step of forming an interlayer insulating film, a step of contact holes, a step of forming metal wires, and a step of forming an organic film are executed in this order, the pixel TFT 11 shown in Fig. 8 is completed.

The interlayer insulating film can be realized by an inorganic insulating film containing silicon (Si), e.g., a SiO₂ film, a SiN film, or a SiNO film, formed, for example, by publicly known plasma CVD or sputtering.

Further, the metal wires can be made of a low-resistance metal such as aluminum (Al), copper (Cu), or silver (Ag), an alloy composed mainly of such a low-resistance metal, or a compound composed mainly of such a low-resistance metal.

Furthermore, the organic film can be realized, for example, by a photosensitive acrylic resin formed by spin coating.

Fig. 9 is a cross-sectional view of a scanning driver TFT 12. As shown in Fig. 9, the scanning driver TFT 12 includes: a polysilicon film, disposed on a transparent substrate 71, which has a source region 74a, a channel region 74b, and a drain region 74c; an insulating film 75 disposed on the polysilicon film; and a gate electrode 76 disposed on the insulating film 75.

The structure of this scanning driver TFT 12 can be realized, for example, as follows: First, an amorphous silicon film is formed by publicly known sputtering, LPCVD, or plasma CVD on one surface of a transparent substrate 71 that has been cleansed. Then, after polycrystallization of the amorphous silicon film by irradiation of a CW solid-state laser, the amorphous silicon film is patterned into a desired shape in a photolithography step to form a polysilicon film having a film thickness of 20 nm to 100 nm, or more preferably 30 nm to 70 nm.

Next, an insulating film 75 having a film thickness of 30 nm to 150 nm, or more preferably 50 nm to 100 nm, is formed on the transparent substrate 71 in such a way as to cover the polysilicon film.

From a point of view of lowering the surface level at the interface with the polysilicon film, it is preferable that the insulating film 75 be a SiO₂ film. Further, the insulating film 75 may be a laminated structure having a plurality of films joined on top of each other.

Next, for adjustment of threshold voltage, the entire surface of the polysilicon film is doped (channel doping) with impurities through the insulating film 75 by publicly known ion injection or ion doping.

For realization of an n-type TFT, the impurities for use in the channel doping may be an element of Family III such as boron (B). Alternatively, for realization of a p-type TFT, the impurities for use in the channel doping may be an element of Family V such as phosphor (P). Further, for treatment of a large-area substrate, ion doping is preferred.

Next, a conducting layer formed by publicly known sputtering on the insulating film 75 is patterned into a desired shape in a photolithography step to form a gate electrode 76 having a film thickness of 100 nm to 500 nm, or more preferably 150 nm to 300 nm.

Next, after a cap film (not illustrated) having a film thickness of 20 nm to 150 nm, or more preferably 30 nm to 100 nm, is formed in such a way as to cover the gate electrode 76, the polysilicon film is doped (source-drain heavy doping) with impurities such as boron (B) or phosphor (P) in a self-aligning manner by publicly known ion injection or ion doping.

The cap film can be realized by an inorganic insulating film containing silicon (Si), e.g., a SiO₂ film, a SiN film, or a SiNO film, formed, for example, by publicly known plasma CVD or sputtering.

Next, after a process of activating the polysilicon film, a high concentration impurity region that functions as the source and drain regions 74a and 74c is formed in a region of the polysilicon film excluding the channel region 74b.

The process of activating the polysilicon film may be realized, for example, by treating the polysilicon film with heat using an annealing oven or the like or irradiating the polysilicon film with an excimer laser or the like.

Finally, after a step of forming an interlayer insulating film, a step of contact holes, a step of forming metal wires, and a step of forming an organic film are executed in this order, the scanning driver TFT 12 shown in Fig. 9 is completed.

The interlayer insulating film can be realized by an inorganic insulating film containing silicon (Si), e.g., a SiO₂ film, a SiN film, or a SiNO film, formed, for example, by publicly known plasma CVD or sputtering.

Further, the metal wires can be made of a low-resistance metal such as aluminum (Al), copper (Cu), or silver (Ag), an alloy composed mainly of such a low-resistance metal, or a compound composed mainly of such a low-resistance metal.

Furthermore, the organic film can be realized, for example, by a photosensitive acrylic resin formed by spin coating.

As described above, Embodiment 1 of the present invention can optimize the respective characteristics of the pixel TFTs 11, the scanning driver TFTs 12, and the data driver TFTs 13 without carrying out polycrystallization more than once using a CW solid-state laser.

This prevents an increase in number of production steps for producing a semiconductor film from which TFTs are formed, thus allowing a reduction in cost of manufacturing liquid crystal displays.

### (Embodiment 2)

The following describes Embodiment 2 of the present invention. The present embodiment is a double-gate-structured pixel TFT 11 in which the gate electrode 66 of a pixel TFT 11 of Embodiment 1 serves as an upper gate electrode and the light blocking film 62 serves as a lower gate electrode.

Fig. 10 is a graph showing a relationship between the potential of the gate electrode 66 serving as an upper gate electrode and the drain current, with variations in the potential (lower potential) of the light blocking film 62 serving as a lower gate electrode. Since, as shown in Fig. 10, a change in lower potential can effect a change in threshold voltage, a threshold-voltage-variable TFT can be realized.

Further, by fixing the lower potential at a predetermined potential, the influence of variations in back-channel potential can be suppressed; therefore, TFT characteristics can be stabilized.

### (Embodiment 3)

The following describes Embodiment 3 of the present invention. In Embodiment 1, as shown in Fig. 4, the scanning direction in which the small-diameter beam laser light 53a to 53d is passed over the amorphous silicon film 52 deposited on the TFT substrate 51 stays the same anywhere on the amorphous silicon film 52.

Moreover, in the pixel TFTs 11 disposed in the display section 101, as shown in Figs. 1 and 2, the channel length directions of the channel regions 34 go along the X direction in the drawings, and the crystal growth direction of the polysilicon film that from which the channel regions 34 are formed is perpendicular to the channel length directions.

Similarly, in the scanning driver TFTs 12 disposed in the scanning driver 102 and the data driver TFTs 13 disposed in the data driver 103, as shown in Figs. 1 and 3, the channel length directions of the channel regions 44 go along the Y direction in the drawings, and the crystal growth direction of the polysilicon film from which the channel regions 44 are formed is parallel to the channel length directions.

On the other hand, the present embodiment is an embodiment in which the scanning direction in which small-diameter beam laser light is passed over an amorphous silicon film deposited on a TFT substrate varies with location on the amorphous silicon film.

Fig. 11 is an explanatory diagram for explaining how an amorphous silicon film deposited on the TFT substrate constituting the display panel 100 is polycrystallized. In the present embodiment, as shown in Fig. 11, over that region of an amorphous silicon film 82 deposited on a TFT substrate 81 which corresponds to the scanning driver 102, small-diameter beam laser light is passed in the direction of an arrow A1 of Fig. 11 along an X direction of Fig. 11. Then, the small-diameter beam laser light thus passed forms a band of light that moves in the direction of an arrow B1 of Fig. 11 so that adjacent bands of light overlap each other.

Further, over a region that corresponds to the data driver 103, small-diameter beam laser light is passed in the direction of an arrow A2 of Fig. 11 along the X direction of Fig. 11. Then, the small-diameter beam laser light thus passed forms a band of light that moves in the direction of an arrow B2 of Fig. 11 so that adjacent bands of light overlap each other.

Furthermore, over a region that corresponds to the display section 101, small-diameter beam laser light is passed in the direction of an arrow A3 of Fig. 11 along a Y direction of Fig. 11. Then, the small-diameter beam laser light thus passed forms a band of light that moves in the direction of an arrow B3 of Fig. 11 so that adjacent bands of light overlap each other.

In this case, the crystal growth direction of the polysilicon film coincides with the direction of the arrow A1 of Fig. 11 in the region corresponding to the scanning driver 102, coincides with the direction of the arrow A2 of Fig. 11 in the region corresponding to the data driver 103, and coincides with the direction of the arrow A3 of Fig. 11 in the region corresponding to the display section 101.

According to the present embodiment, the scanning direction in which the small-diameter beam laser light is passed over the amorphous silicon film deposited on the TFT substrate varies with location on the amorphous silicon film, whereby the crystal growth direction of the polysilicon film can vary from one region to another.

For this reason, the respective channel directions of the pixel TFTs 11, the scanning driver TFTs 12, and the data driver TFTs 13 can be disposed with a higher degree of freedom and a reduction in design cost.

### (Other Embodiments)

The present invention is not limited to the description of the embodiments above, but may be altered by a skilled person within the scope of the claims. An embodiment based on a proper combination of technical means disclosed in different embodiments is encompassed in the technical scope of the present invention.

For example, although, in Embodiment 1, the pixel TFTs 11 are top-gate-structured TFTs, the pixel TFTs 11 may be bottom-gate-structured TFTs. In the case of realization of bottom-gate-structured TFTs, it is only necessary to use the light blocking film 62 of each pixel TFT 11 as a gate electrode. In this case, the need for a gate electrode 66 is eliminated.

Similarly, the scanning driver TFTs 12 and the data driver TFTs 13 may be bottom-gate-structured TFTs.

Although Embodiments 1 to 3 above have been described by using the pixel TFTs 11 as TFTs making up the display section 101, the TFTs can be used as photodiodes (sensing elements) that are utilized as a light sensor (sensing section) of a touch panel, an ambient light sensor, etc. In this case, the polysilicon film formed on the insulating film has a PIN structure in which an intrinsic semiconductor region is disposed between a p-type semiconductor region and an n-type semiconductor region. A semiconductor film having such a structure can function as a planar photodiode (thin-film diode).

Further, above the photodiode, a cap film and an interlayer insulating film is formed in this order from the substrate. Furthermore, the p-type semiconductor region and the n-type semiconductor region are electrically connected to wires through contact holes. Moreover, an organic film is formed in such a way as to cover the wires and the interlayer insulating layer. The light blocking film disposed below the polysilicon film so as to block light coming from the substrate allows the photodiode to detect only light coming from the side opposite to the substrate.

Although, in Embodiments 1 to 3 above, a semiconductor element is formed from a polysilicon film having grown as a crystal in a direction perpendicular or parallel to the channel length direction, it is not necessary to structure all the semiconductor elements in that manner in the liquid crystal display device (display device).

Further, although the present invention has been described with reference to implementation methods using anisotropy in crystal growth direction as generated during polycrystallization using a CW solid-state laser, the same effects can be expected from SELAX and SLS, which are other means for obtaining semiconductor elements having anisotropy in crystal growth direction.

As described above, a display panel according to the present invention is a display panel including: a transparent substrate; a semiconductor film disposed above or on the transparent substrate; and a plurality of semiconductor elements respectively having current paths, the current paths being formed from the semiconductor film, the semiconductor film being polycrystallized by irradiation of laser light so as to have a crystal growth direction that goes along a scanning direction of the laser light, the plurality of semiconductor elements including: first semiconductor elements disposed above or on the transparent substrate so that the crystal growth direction of the semiconductor film is substantially perpendicular to directions of the current paths of the first semiconductor elements; and second semiconductor elements disposed above or on the transparent substrate so that the crystal growth direction of the semiconductor film is substantially parallel to directions of the current paths of the second semiconductor elements.

In the display panel above, when the semiconductor film disposed above or on the transparent substrate is polycrystallized by irradiation of laser light, the growth of a crystal in a direction that goes along a scanning direction of the laser light is achieved.

Moreover, as semiconductor elements using the semiconductor film as their respective current paths, first semiconductor elements are disposed above or on the transparent substrate so that the directions of the current paths of the first semiconductor elements are substantially perpendicular to the crystal growth direction of the semiconductor film, and second semiconductor elements are disposed above or on the transparent substrate so that the directions of the current paths of the second semiconductor elements are substantially parallel to the crystal growth direction of the semiconductor film.

That is, by disposing semiconductor elements as described above with respect to a semiconductor film having a crystal growth direction that goes along a scanning direction of laser beam, first semiconductor elements the directions of whose current paths are substantially perpendicular to the crystal growth direction of the semiconductor film and second semiconductor elements the directions of whose current paths are substantially parallel to the crystal growth direction of the semiconductor film can be realized.

This makes it possible to realize first and second semiconductor elements having different characteristics from each other due to a difference in direction of current paths with respect to the crystal growth direction of a semiconductor film, thus making it possible to reduce the cost of manufacturing display panels using these two types of semiconductor elements, i.e., first and second semiconductor elements.

It is preferable that the first semiconductor elements be first thin-film transistors wherein the semiconductor film is used as their current paths each of which is made up of a channel region, a source region, and a drain region, and that the second semiconductor elements be second thin-film transistors wherein the semiconductor film is used as their current paths each of which is made up of a channel region, a source region, and a drain region. Further, it is preferable that a channel length direction of the channel region of the first thin-film transistor be substantially perpendicular to the crystal growth direction of the semiconductor film, and a channel length direction of the channel region of the second thin-film transistor be substantially parallel to the crystal growth direction of the semiconductor film.

In this case, the first semiconductor elements are realized as first thin-film transistors whose channel length directions are substantially perpendicular to the crystal growth direction of the semiconductor film, and the second semiconductor elements is realized as second thin-film transistors whose channel length directions are substantially parallel to the crystal growth direction of the semiconductor film.

This makes it possible to realize two types of thin-film transistors having different characteristics from each other, i.e., the first thin-film transistors having low leak current characteristics and the second thin-film transistors having high-mobility characteristics.

It is preferable that the display panel further include: a display section having a plurality of pixel sections disposed therein; and driving sections respectively having driving circuits each of which outputs driving signals for driving the pixel sections of the display section, wherein the display section having the plurality of first thin-film transistors which are disposed in one-to-one correspondence with the pixel sections of the display section and opening and closing of which are controlled on the basis of the driving signals outputted from the driving circuits of the driving sections, and each of the driving sections has the plurality of second thin-film transistors making up the driving circuit of the driving section.

In this case, thin-film transistors for respectively driving the pixel sections of the display section can be formed by the first thin-film transistors having low leak current characteristics. This makes it possible to suppress deterioration in quality of an image that is displayed by the display section. Furthermore, the driving circuit of the driving section can be made up of the second thin-film transistors having high-mobility characteristics. This makes it possible to drive the pixel sections of the display section at high speeds.

It is preferable that the display panel further include: a sensing section having a plurality of sensing elements each of which senses light incident from a side of the transparent substrate facing the semiconductor film, the sensing section having the plurality of first thin-film transistors respectively forming the sensing elements of the sensing section.

In this case, the sensing elements of the sensing section can be respectively formed by the first thin-film transistors having low leak current characteristics. This makes it possible to improve the light-sensing accuracy of the sensing section.

It is preferable that the display panel further include: a sensing section having a plurality of sensing elements each of which senses light incident from a side of the transparent substrate facing the semiconductor film, the first semiconductor elements being thin-film diodes each of which has a PIN structure formed from the semiconductor film, the sensing section having the plurality of thin-film diodes respectively forming the sensing elements of the sensing section.

The term "PIN structure" here means a structure in which an intrinsic semiconductor free of impurities or a semiconductor having a lower impurity concentration than a p-type semiconductor and an n-type semiconductor is interposed between a p-type semiconductor and an n-type semiconductor. This PIN structure allows the first semiconductor elements to be utilized as planar PIN photodiodes.

In this case, the sensing elements of the sensing section can be respectively formed by the thin-film diodes having low leak current characteristics. This makes it possible to improve the light-sensing accuracy of the sensing section.

It is preferable that the semiconductor film be polycrystallized by irradiation of CW solid-state laser light.

In this case, the growth of a crystal along a scanning direction of laser light can be realized with high accuracy.

It is preferable that the semiconductor film be polycrystallized by a single irradiation of the laser light.

In this case, since the semiconductor film is irradiated with the laser light only once, the number of manufacturing steps required for polycrystallization of the semiconductor film can be reduced and, as a result, a reduction in cost of manufacturing display panels can be more effectively achieved.

It is preferable that the semiconductor film be a silicon film.

In this case, the first and second semiconductor elements formed from a silicon film can be realized with high accuracy.

A display device according to the present invention includes: a display panel described above; and a control device for controlling image display processing performed by the display panel.

The display device realizes a display device including a display panel described above.

### Industrial Applicability

The present invention can be applied to a display panel having peripheral driving circuits built-in and a display device using such a display panel. Specifically, usable examples of the display device include: an active-matrix liquid crystal display device; an electrophoretic display; a twist-ball display; a reflective display using a fine prism film; a display using a light modulation device such as a digital mirror device; a display using as an light-emitting element an element, such as an organic EL light-emitting element, an inorganic EL light-emitting element, or an LED (light-emitting diode), whose light-emitting luminance is variable; a field emission display; and a plasma display.

Reference Signs List
- 11: Pixel TFT (first semiconductor element, first thin-film transistor)
- 12: Scanning driver TFT (second semiconductor element, second thin-film transistor)
- 13: Data driver TFT (second semiconductor element, second thin-film transistor)
- 21: Gate wire
- 22: Source wire
- 31, 41, 66, 76: Gate electrode
- 32, 42: Source electrode
- 33, 43: Drain electrode
- 34, 44, 64b, 74b: Channel region (current path)
- 51, 81: TFT substrate
- 52,: 58 Amorphous silicon film (semiconductor film)
- 53a, 53b, 53c, 53d: Small-diameter beam laser light (laser light)
- 61, 71: Transparent substrate
- 62: Light blocking film
- 63, 65, 75: Insulating film
- 64a, 74a: Source region
- 64c, 74c: Drain region
- 100: Display panel
- 101: Display section
- 102: Scanning driver
- 103: Data driver

## Claims

1. A display panel, comprising:
a transparent substrate;
a semiconductor film disposed above or on the transparent substrate; and
a plurality of semiconductor elements respectively having current paths, the current paths being formed from the semiconductor film,
the semiconductor film being polycrystallized by irradiation of laser light so as to have a crystal growth direction that goes along a scanning direction of the laser light,
the plurality of semiconductor elements including:
first semiconductor elements disposed above or on the transparent substrate so that the crystal growth direction of the semiconductor film is substantially perpendicular to directions of the current paths of the first semiconductor elements; and
second semiconductor elements disposed above or on the transparent substrate so that the crystal growth direction of the semiconductor film is substantially parallel to directions of the current paths of the second semiconductor elements.

2. The display panel according to claim 1, wherein
the first semiconductor elements are first thin-film transistors wherein the semiconductor film is used as their current paths each of which is made up of a channel region, a source region, and a drain region, and
the second semiconductor elements are second thin-film transistors wherein the semiconductor film is used as their current paths each of which is made up of a channel region, a source region, and a drain region.

3. The display panel according to claim 2, wherein
a channel length direction of the channel region of the first thin-film transistor is substantially perpendicular to the crystal growth direction of the semiconductor film, and a channel length direction of the channel region of the second thin-film transistor is substantially parallel to the crystal growth direction of the semiconductor film.

4. The display panel according to claim 2 or 3, further comprising:
a display section having a plurality of pixel sections disposed therein; and
driving sections respectively having driving circuits each of which outputs driving signals for driving the pixel sections of the display section, wherein
the display section having the plurality of first thin-film transistors which are disposed in one-to-one correspondence with the pixel sections of the display section and opening and closing of which are controlled on the basis of the driving signals outputted from the driving circuits of the driving sections, and
each of the driving sections has the plurality of second thin-film transistors making up the driving circuit of the driving section.

5. The display panel according to any one of claims 2 through 4, further comprising:
a sensing section having a plurality of sensing elements each of which senses light incident from a side of the transparent substrate facing the semiconductor film,
the sensing section having the plurality of first thin-film transistors respectively forming the sensing elements of the sensing section.

6. The display panel according to claim 1, further comprising:
a sensing section having a plurality of sensing elements each of which senses light incident from a side of the transparent substrate facing the semiconductor film,
the first semiconductor elements being thin-film diodes each of which has a PIN structure formed from the semiconductor film,
the sensing section having the plurality of thin-film diodes respectively forming the sensing elements of the sensing section.

7. The display panel according to any one of claims 1 through 6, wherein
the semiconductor film is polycrystallized by irradiation of CW solid-state laser light.

8. The display panel according to any one of claims 1 through 7, wherein
the semiconductor film is polycrystallized by a single irradiation of the laser light.

9. The display panel according to any one of claims 1 through 8, wherein
the semiconductor film is a silicon film.

10. A display device, comprising:
a display panel according to any one of claims 1 through 9; and
a control device for controlling image display processing performed by the display panel.
